Europäisches Patentamt

European Patent Office

Office européen des brevets

(11) Numéro de publication: **0 020 233**
**A1**

## (12) DEMANDE DE BREVET EUROPEEN

(21) Numéro de dépôt: **80400695.5**

(22) Date de dépôt: **20.05.80**

(51) Int. Cl.³: **H 01 L 27/06,** H 01 L 27/08, H 01 L 27/02

(30) Priorité: **29.05.79 FR 7913630**

(43) Date de publication de la demande: **10.12.80 Bulletin 80/25**

(84) Etats contractants désignés: **DE GB IT NL**

(71) Demandeur: **"THOMSON-CSF" - SCPI, 173, Boulevard Haussmann, F-75360 Paris Cedex 08 (FR)**

(72) Inventeur: **Quoirin, Jean-Baptiste, "THOMSON-CSF" SCPI 173, bld Haussmann, F-75360 Paris Cedex 08 (FR)**

(74) Mandataire: **de Beaumont, Michel et al, "THOMSON-CSF" SCPI 173, Bld Haussmann, F-75360 Paris Cedex 08 (FR)**

(54) **Structure intégrée comportant un transistor et trois diodes antisaturation.**

(57) La présente invention concerne une structure intégrée comportant un transistor et trois diodes anti-saturation.

La structure selon la présente invention comprend un transistor principal (T1) formé des couches (108, 106 et 100), une première diode (D1) constituée des couches (114 et 100), une deuxième diode (D2) constituée des couches (115, 116 et 106), et une troisième diode (D3) constituée des couches (118, 120 et 106).

Application aux transistors de commutation.

EP 0 020 233 A1

ACTORUM AG

# STRUCTURE INTEGREE COMPORTANT UN TRANSISTOR
# ET TROIS DIODES ANTI-SATURATION

La présente invention concerne une structure intégrée comprenant un montage à transistor, le transistor d'entrée étant muni de diodes anti-saturation, ainsi que le procédé de fabrication d'une telle structure.

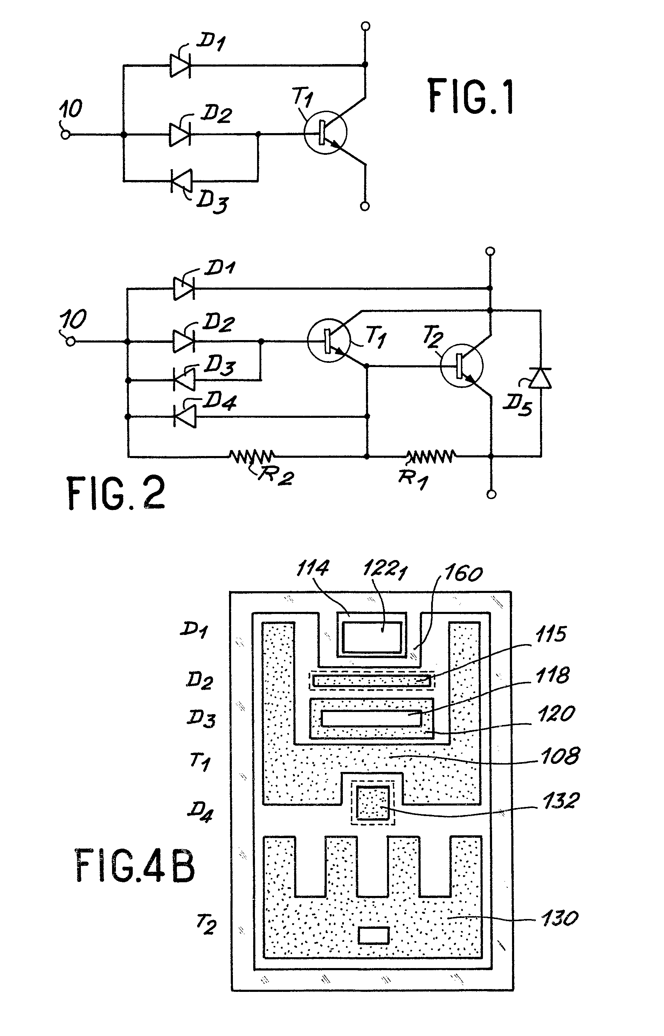

Il est connu dans la technique que pour améliorer certaines caractéristiques d'un transistor, notamment pour des transistors de puissance fonctionnant en commutation, il peut être souhaitable d'associer à ce transistor trois diodes, dites diodes d'anti-saturation, connectées de la façon représentée en figure 1. L'entrée vers la base du transistor NPN T1 se fait par l'intermédiaire de deux diodes en anti-parallèle D2 et D3. Cette entrée est connectée au collecteur du transistor T1 par l'intermédiaire d'une diode D1 orientée de la façon représentée dans la figure.

Cette prévision de diodes anti-saturation s'applique également, comme cela est connu dans la technique , au cas d'un montage Darlington comme cela est représenté dans la figure 2. On peut voir dans cette figure, outre les éléments déjà décrits en relation avec la figure 1, un transistor T2 dont la base est reliée à l'émetteur du transistor T1 et le collecteur au collecteur du transistor T1, cette connexion commune de collecteur servant de sortie collecteur du montage et l'émetteur du transistor T2 servant de sortie d'émetteur du montage Darlington. De façon générale, il est également prévu une résistance R1 entre les émetteurs des transistors T1 et T2 et une résistance R2 entre l'émetteur du transistor T1 et l'entrée 10 du circuit. En outre, une diode D4, couramment appelée diode de déstockage, est souvent incluse dans un montage Darlington entre l'émetteur et la base du transistor T1 (ou plutôt, dans le cas particulier représenté, l'entrée 10) pour diminuer le temps de stockage du circuit. Une diode de sortie D5 peut être présente entre l'émetteur et le collecteur du transistor T2.

On connaît dans la technique, des circuits incluant les transistors T1, T2 et la diode D4 sous forme intégrée.

La présente invention a pour objet de prévoir un circuit intégré monolithique incluant le transistor T1 et l'ensemble de ses diodes d'anti-saturation D1, D2, D3, cette intégration étant compatible avec l'intégration d'un ensemble Darlington comme dans le cas de la figure 2. Dans la pratique, chacune des diodes D1, D2, D3 et D4 peut en fait être constituée de plusieurs diodes en série.

Pour atteindre cet objet, la présente invention prévoit une structure intégrée comprenant un substrat d'un premier type de conductivité dont la face inférieure sert de collecteur ; une première couche de base d'un deuxième type de conductivité recouvrant la plus grande partie de la face supérieure du substrat ; une deuxième couche d'émetteur du premier type de conductivité recouvrant la plus grande partie de la première couche, la face inférieure du substrat étant recouverte d'une métallisation de collecteur et la deuxième couche d'émetteur étant recouverte d'une métallisation d'émetteur ; une première zone du deuxième type de conductivité, formée dans la face supérieure du substrat et séparée de la première couche ; une deuxième zone du premier type de conductivité formée dans un premier caisson du deuxième type de conductivité à niveau de dopage élevé ménagé dans la première couche ; une troisième zone du deuxième type de conductivité formée dans un deuxième caisson du premier type de conductivité ménagé dans la première couche ; une première métallisation reliant les faces supérieures apparentes des première , deuxième et troisième zones ; et une deuxième métallisation reliant les faces supérieures apparentes du deuxième caisson et de la première couche. Selon un aspect de l'invention, chacun des premier et deuxième caissons peut contenir plusieurs diodes en série emboîtées.

Ces objets, caractéristiques et avantages ainsi que d'autres de la présente invention seront exposés plus en détail dans la description suivante de modes de réalisation particuliers faite en relation avec les figures jointes parmi lesquelles :

- les figures 1 et 2 représentent sous forme symbolique les circuits que vise à réaliser la structure intégrée selon la présente invention ;

- la figure 3A représente une vue en coupe schématique d'un mode de réalisation de structure intégrée associant un transistor et ses diodes anti-saturation selon la présente invention ;

- les figures 3B et 3C représentent diverses vues de dessus correspondant à des variantes du mode de réalisation de la figure 3A ;

- la figure 4A représente une vue en coupe schématique d'un montage Darlington muni d'une diode de déstockage et de diodes anti-saturation intégrées selon un mode de réalisation de la présente invention ; et

- la figure 4B représente une vue de dessus correspondant au mode de réalisation de la figure 4A.

On notera que dans les diverses figures, comme cela est classique dans les représentations schématiques de dispositifs à semiconducteur, ni les épaisseurs, ni les dimensions relatives des diverses couches et surfaces ne sont tracées à l'échelle. Pour une réalisation pratique, l'homme de l'art se référera aux connaissances technologiques usuelles dans le domaine considéré.

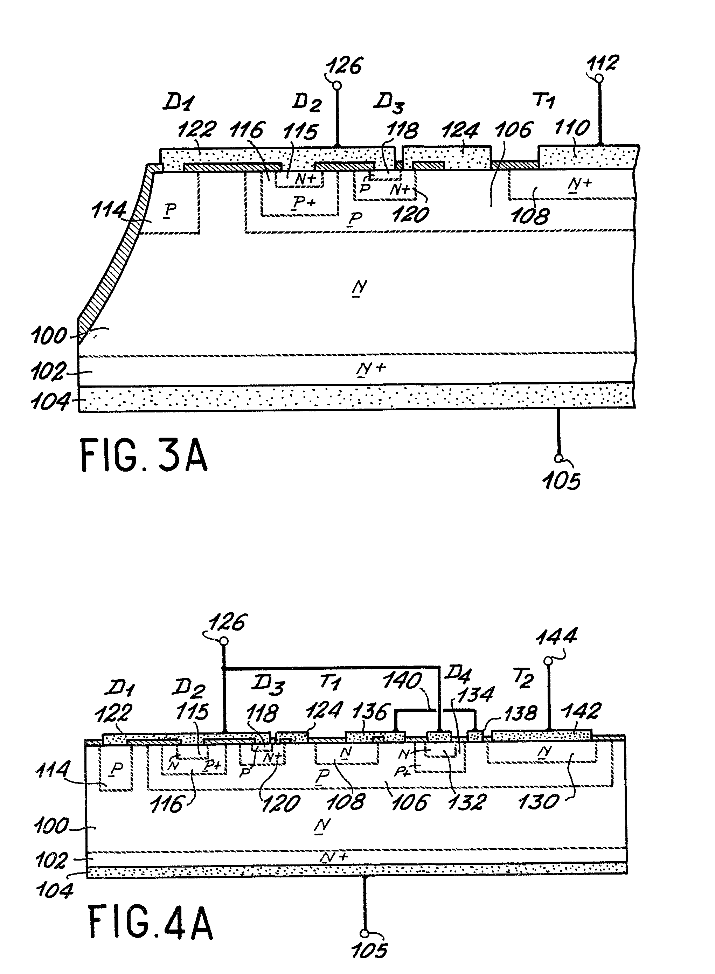

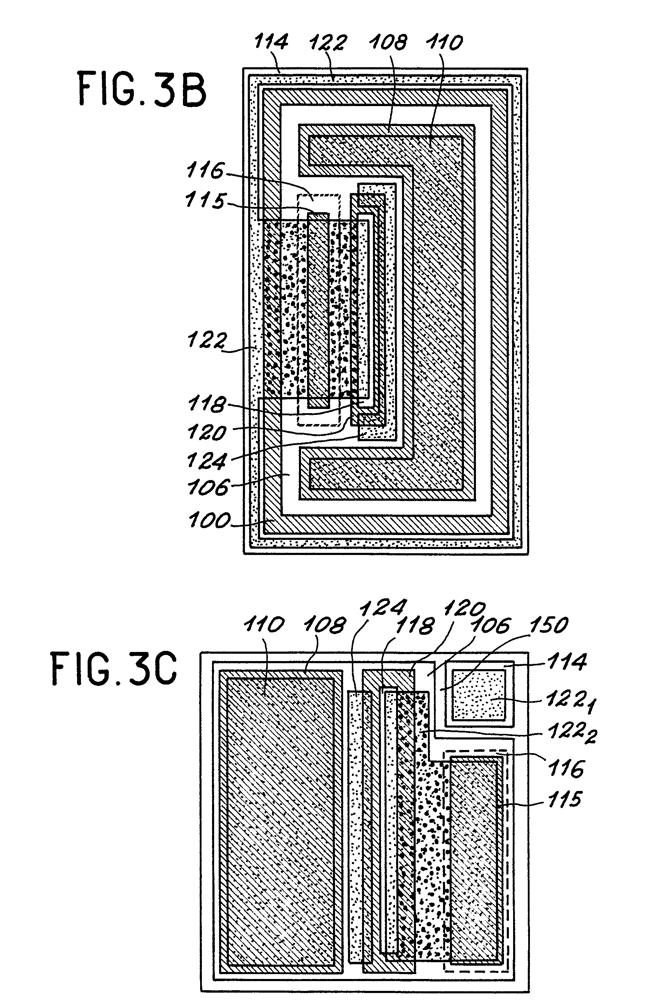

La figure 3A représente une vue en coupe schématique d'une structure intégrée selon la présente invention mettant en oeuvre le circuit de la figure 1. On a indiqué en haut de la figure pour faciliter la compréhension, les zones correspondant sensiblement aux diodes D1, D2 et D3 et au transistor T1. La structure de la figure 3A comprend un substrat 100 de type N dont la face inférieure est une couche 102 de type $N^+$ revêtue d'une métallisation 104 reliée à une borne 105. La couche de type N peut être obtenue par épitaxie à partir d'un substrat $N^+$ ou , au contraire, on peut partir d'un substrat de type N et former la couche $N^+$ par diffusion. Le transistor T1 qui occupe la plus grande partie de la surface de la plaquette comprend une couche de base 106 du type P et une couche 108 d'émetteur de type N. La couche 108 de type N est revêtue d'une métallisation d'émetteur 110 reliée à une borne 112. La couche de base 106 est interrompue pour permettre la formation d'une zone de type P séparée 114 pour former avec la couche 100 la diode D1. Pour obtenir cette zone de type P séparée, on peut , ou bien procéder à la formation d'une couche P uniforme à la surface supérieure du substrat et isoler une portion de cette couche par creusage d'un sillon délimitant la zone 114 (voir figure 3C), ou bien procéder par diffusion à travers un masque pour former séparément la couche 106 et la zone 114 (voir figure 3B).

La diode D2 est formée dans la chouche 106 de type P sous forme d'une zone $N^+$ 115 dans un caisson $P^+$ 116. La diode D3 est également formée dans la couche 106 de type P sous forme d'une zone P 118 dans un caisson $N^+$ 120. La zone P 114, la zone $N^+$ 115 et la zone P 118 sont connectées par une métallisation 122. Le caisson $N^+$ 120 et la couche de base 106 du transistor T1 sont connectés par une métallisation 124. La métallisation 122 est reliée à une connexion d'entrée 126.

Alors que la fabrication du transistor T1 seul ne mettrait en jeu que deux étapes de diffusion-masquage sur la surface supérieure du substrat 100 (une diffusion pour la formation de la couche 106 de type P et une diffusion pour la formation de la couche 108 de type N), la réalisation de la structure intégrée selon la présente invention met en jeu deux étapes de diffusion-masquage supplémentaires pour la diffusion des diodes D2 et D3 et plus particulièrement du caisson $P^+$ 116 et de la couche P 118. La séquence des étapes de diffusion-masquage est la suivante :

6

- formation de la couche P 106 et de la zone P 114

- formation du caisson $P^+$ 116

- formation de la couche $N^+$ 108, de la zone $N^+$ 115 et du caisson $N^+$ 120

- formation de la zone P 118.

On notera que, si le caisson $N^+$ 120 est nécessaire pour obtenir une diode D3 selon la bonne polarité, le caisson $P^+$ 116 n'a pas un rôle fondamental mais a pour but de réduire le gain du transistor parasite vertical qui serait constitué par la zone 115, la couche 106 et le collecteur de la structure. Au lieu de ce caisson, on pourrait utiliser d'autres procédés connus dans la technique pour diminuer le gain d'un transistor parasite. Par exemple, il pourrait être prévu au lieu du caisson $P^+$ 116, au voisinage de la jonction entre la zone $N^+$ 115 et la couche P 106, une diffusion d'or ou un bombardement électronique pour réduire la durée de vie des porteurs dans cette zone et réduire ainsi le gain du transistor parasite vertical. De même, il est souhaitable de rendre la diode D1 particulièrement rapide et on pourra également prévoir une irradiation électronique ou une diffusion à l'or dans cette zone. Si l'on choisit cette solution qui consiste à réduire la durée de vie des porteurs par irradiation électronique ou diffusion d'or, cette irradiation ou cette diffusion seront effectuées simultanément dans les zones correspondant aux diodes D1 et D2.

Dans la figure 3A, les zones hachurées correspondent à des couches de silice destinées à passiver les affleurements de jonction et à éviter leur mise en court-circuit par les diverses métallisations.

7

La figure 3B représente une vue de dessus d'un mode de réalisation d'une structure intégrée correspondant à la coupe schématique de la figure 3A. Les zones blanches correspondent à des diffusions de type P ; les zones hachurées à des diffusions de type N ; les zones en pointillés à des métallisations ; et les zones à points noirs à des métallisations sur couche d'oxyde isolante. La diffusion 116 entoure complètement la structure. On notera que l'ensemble de la structure pourrait être entouré d'une zone hachurée si la diffusion 114 (diode D1) était entourée de part et d'autre par une remontée de la couche N de collecteur 100, c'est-à-dire dans le cas d'une structure de type planar. Bien entendu la vue de dessus détaillée de la figure 3B ne constitue qu'un exemple de configuration parmi de nombreuses configurations de masques possibles.

La figure 3C représente une vue de dessus d'un autre mode de réalisation d'une structure intégrée correspondant à la coupe schématique de la figure 3A. Dans l'exemple représenté, la structure est de type mesa et la diffusion 114 est séparée de la couche 106 par un sillon 150. Dans certains cas, il est difficile de déposer une métallisation 122 recouvrant le sillon 150. On a donc représenté dans la figure, la métallisation 122 sous forme de deux métallisations $122_1$ et $122_2$ . Pour connecter ces métallisations, on pourra former sur chacune d'elles une bille conductrice et relier ces billes par une barrette.

Dans les figures 3B et 3C, on a utilisé les mêmes références que dans la figure 3A pour désigner des éléments et couches correspondants.

La figure 4A illustre une vue en coupe schématique d'un mode de réalisation d'intégration selon la présente invention d'un circuit tel que celui illustré en figure 2 (à l'exclusion des résistances R1 et R2). On retrouve dans la partie gauche de cette figure les divers éléments déjà décrits en relation avec la figure 3A et désignés par les mêmes références. On a à nouveau indiqué à la partie supérieure de la figure les zones correspondant sensiblement aux emplacements des diodes D1, D2, D3 et D4 et aux transistors T1 et T2. Dans la couche de base 106 est en outre formée une couche d'émetteur du transistor principal T2, cette couche de type N étant désignée par la référence 130. La diode D4 est formée d'une zone N 132 ménagée dans un caisson de type P$^+$ 134. La couche de type N 108 constituant l'émetteur du transistor T1 est reliée à la couche de base 106 du transistor T2. Cette connexion est représentée dans la figure par les métallisations 136 et 138 ainsi que par le conducteur 140. Dans la pratique, cet ensemble 136, 138 et 140 constitue une métallisation unique qui a été représentée sous cette forme uniquement pour simplifier la représentation de la vue en coupe. L'émetteur 130 du transistor T2 est recouvert d'une métallisation 142 reliée à une borne de connexion 144 constituant la sortie d'émetteur du montage Darlington. A nouveau, comme dans le cas de la figure 3A, les caissons de type P$^+$ 116 et 134 pourraient être remplacés par des diffusions d'or ou une irradiation électronique effectuées au voisinage des zones 115 et 132 en même temps d'ailleurs qu'au voisinage de la zone 114 constituant la diode D1.

La figure 4B représente une vue de dessus d'un mode de réalisation d'une structure intégrée correspondant à la coupe schématique de la figure 4A. De mêmes références désignent des couches et zones correspondantes. Ici la zone 114 est isolée par un sillon 160.

Bien entendu la présente invention est susceptible de nombreuses variantes. Par exemple, l'irradiation électronique peut être remplacée par une irradiation aux rayons X ou gamma.

10

REVENDICATIONS

1 - Structure intégrée monolithique comportant un transistor et ses trois diodes anti-saturation, comprenant un substrat (100) d'un premier type de conductivité dont la face inférieure constitue le collecteur du transistor ; une première couche de base (106) d'un deuxième type de conductivité recouvrant la plus grande partie de la face supérieure du substrat ; et une deuxième couche d'émetteur (108) du premier type de conductivité recouvrant la plus grande partie de la première couche ; la face inférieure du substrat étant recouverte d'une métallisation de collecteur (104) et la deuxième couche d'émetteur étant recouverte d'une métallisation d'émetteur (110) ; caractérisée en ce qu'elle comprend :

- une première zone (114) du deuxième type de conductivité formée dans la face supérieure du substrat et séparée de la première couche ;

- une deuxième zone (115) du premier type de conductivité formée dans un premier caisson (116) ménagé dans la première couche (106) ;

- une troisième zone (118) du deuxième type de conductivité formée dans un deuxième caisson (120) du premier type de conductivité ménagé dans la première couche ;

- une première métallisation (122) reliant les faces supérieures apparentes des première (114), deuxième (115) et troisième (118) zones ; et

- une deuxième métallisation (124) reliant les faces supérieures apparentes du deuxième caisson (120)

11

et de la première couche (106).

2 - Structure selon la revendication 1, caractérisée en ce que le premier caisson (116) est constitué d'une zone du deuxième type de conductivité.

3 - Structure selon la revendication 1, caractérisée en ce que le premier caisson est constitué d'une partie de la première couche dans laquelle la durée de vie des porteurs a été réduite par un processus du type diffusion d'or ou irradiation .

4 - Structure selon la revendication 1, caractérisée en ce qu'elle comprend en outre des couches, zones et métallisations propres à former un second transistor connecté au premier selon un montage Darlington.

5 - Procédé de fabrication de structure selon la revendication 1, à partir d'un substrat d'un premier type de conductivité, caractérisé en ce qu'il comprend les étapes suivantes :

a) former simultanément la première couche (106) et la première zone (114) ;

b) former le premier caisson (116) ;

c) former simultanément la deuxième zone (115), le deuxième caisson (120) et la deuxième couche (108) ; et

d) former la troisième zone (118).

6 - Procédé selon la revendication 5, caractérisé en ce que les diverses étapes sont des étapes de masquage-diffusion et en ce que le premier caisson est constitué d'une couche du deuxième type de conductivité.

BAD ORIGINAL

12

7 - Procédé selon la revendication 5, caractérisé en ce que les étapes a) , c) et d)  sont des étapes de masquage-diffusion et en ce que l'étape  b) est une étape de diffusion d'or réalisée simultanément au voisinage des première et deuxième zones.

8 - Procédé selon la revendication 5, caractérisé en ce que l'étape a) , c) et d) sont des étapes de diffusion et en ce que l'étape  b) est une étape d'irradiation électronique réalisée au voisinage de la première zone simultanément avec une irradiation au voisinage de la deuxième zone.

FIG.1

FIG.2

FIG.4B

FIG. 3A

FIG.4A

FIG.3B

114  122  108  110

116
115
122
118
120
124
106
100

FIG.3C

110  108  124  118  120  106  150
114
$122_1$
$122_2$
116
115

**Office européen des brevets**

## RAPPORT DE RECHERCHE EUROPEENNE

| Catégorie | Citation du document avec indication, en cas de besoin, des parties pertinentes | Revendica-tion concernée |
|---|---|---|
| | **DOCUMENTS CONSIDERES COMME PERTINENTS** | |
| | FR - A - 2 101 228 (IBM)  <br> * Page 4, lignes 21-35; figures 2,2A * <br><br> -- | 1,2,5, 6 |
| | US - A - 3 913 213 (T.G. MILLS et al. ) <br> * Figures 1-5; colonne 2, ligne 35 - colonne 4, ligne 25 * <br><br> -- | 1,4 |
| | US - A - 4 072 981 (C.T. BLACK et al. ) <br> * Figures 1-3; colonne 3, ligne 11 - colonne 4, ligne 47 * <br><br> -- | 1,2, 4-6 |
| | US - A - 4 138 690 (K.NAWA et al.) <br> * Figures 1-12; colonne 2, ligne 18 - colonne 5, ligne 47 * <br><br> -- | 1,3-7 |
| | FR - A - 2 282 721 (RCA CORP.) <br> * Page 8, ligne 30 - page 9, ligne 24; figure 3 * <br><br> -- | 1,2, 5,6 |
| | FR - A - 2 377 706 (RTC) <br> * Figures 1-5; revendications * <br><br> ---- | 1 |

### CLASSEMENT DE LA DEMANDE (Int. Cl. ³)

H 01 L 27/06
27/08
27/02

### DOMAINES TECHNIQUES RECHERCHES (Int. Cl. ³)

H 01 L 27/06
27/08
27//2

### CATEGORIE DES DOCUMENTS CITES

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche <br> La Haye | Date d'achevement de la recherche <br> 04-09-1980 | Examinateur <br> CARDON |
|---|---|---|

OEB Form 1503.1 06.78